# EUROPEAN PATENT SPECIFICATION

(11) **EP 1 884 956 B1**
(45) Date of publication and mention of the grant of the patent: **21.03.2012**
(21) Application number: 06126208.5
(22) Date of filing: 15.12.2006
(51) Int. Cl.: G11C 16/04, G11C 16/10, H01L 21/8247

(54) **Non-volatile memory device having pass transistors and method of operating the same**
Nichtflüchtiges Speichergerät mit Pass-Transistoren und Betriebsverfahren dafür
Dispositif de mémoire non volatile ayant des transistors de passage et leurs procédés de fonctionnement

(30) Priority: 27.07.2006 KR 20060070881
(43) Date of publication of application: 06.02.2008
(73) Proprietor: Samsung Electronics Co., Ltd., Suwon-si, Gyeonggi-Do (KR)
(72) Inventor: Kim, Won-joo ,Samsung Adv. Inst. of Tech., Gyeonggi-do (KR); Kim, Suk-pil ,c/o Samsung Adv. Inst. of Tech., Gyeonggi-do (KR); Hyun, Jae-woong ,c/o Samsung Adv. Inst. of Tech., Gyeonggi-do (KR); Park, Yoon-dong ,c/o Samsung Adv. Inst. of Tech., Gyeonggi-do (KR); Koo, June-mo ,c/o Samsung Adv. Inst. of Tech., Gyeonggi-do (KR)
(74) Representative: Greene, Simon Kenneth

(56) References cited:
- EP-A- 1 164 596
- EP-A- 1 256 960
- US-A1- 2004 070 020

## Description

### BACKGROUND OF THE INVENTION

The present invention relates to a semiconductor device, and more particularly, to a non-volatile memory device and a method of operating the same.

Conventional non-volatile memory devices, for example, flash memory devices, have NAND type and NOR type structures. The NAND type and NOR type flash memory devices have a fast erase characteristic using a block erase characteristic in common. However, since the NAND type and NOR type flash memory devices have different characteristics in a program, a reading method and integration degree, they are respectively first used in defined fields.

Since the NAND type flash memory devices use a Fowler-Nordheim (F-N) tunneling method, a program speed is fast, a program efficiency is high and the area of a cell in each bit is small so that an integration rate is high. On the other hand, in the NAND type flash memory devices, a random access is difficult. They have disadvantages such as a slow reading speed and a difficulty for selective programming for a specific cell.

Since the random access is easy in the NOR type flash memory devices, they have advantages such as a fast reading speed and facilitation for selective programming. On the other hand, since the NOR type flash memory devices use a channel hot electron injection (CHEI) method, a program speed is low, a program efficiency is low and the area of a cell in each bit is large so that an integration rate is low.

Accordingly, non-volatile memory devices including both advantages of the NAND type flash memory devices and the NOR type flash memory devices are required.

US2004/0070020 describes a nonvoltatile semiconductor memory device according to the preamble of claim 1, which in an embodiment provides a word line connected to first and second memory transistors and respective transistors between the memory transistors and bit lines.

### SUMMARY OF THE INVENTION

The present invention provides a non-volatile memory device which can overcome simultaneously some drawbacks of an NAND type flash memory device and an NOR type flash memory device.

The present invention also provides a method of operating the non-volatile memory device with reliability.

According to an aspect of the present invention, there is provided a non-volatile memory device according to claim 1.

According to another aspect of the present invention, there is provided a non-volatile memory device in which the non-volatile memory device according to the aspect of the present invention is used as unit cells. A plurality of the unit cells are serially arranged on the string, and the word line is shared in the unit cells.

The first or second bit line may be shared in two adjacent unit cells among the unit cells.

According to another aspect of the present invention, there is provided a non-volatile memory device in which the non-volatile memory device according to the aspect of the present invention is used as unit cells. A plurality of the unit cells are arranged in a plurality of rows. A first pass line connects the first pass gates in the unit cells arranged in the rows in common. A second pass line connects the second pass gates in the unit cells arranged in the rows in common. A third pass line connects the third pass gates in the unit cells arranged in the rows in common. The first, second and third bit lines are shared in the unit cells arranged in the rows. According to another aspect of the present invention, there is provided a

According to another aspect of the present invention, there is provided a method of operating a non-volatile memory device by which the non-volatile memory device according to the aspect of the present invention operates. At least one memory transistor of the first and second memory transistors is selected and data is programmed in the selected memory transistor using tunneling of charges. At least one memory transistor of the first and second memory transistors is selected and data is read in the selected memory transistor. And, the data in the first and second memory transistors is erased at one time.

### BRIEF DESCRIPTION OF THE DRAWINGS

The above and other aspects of the present invention will become more apparent by describing in detail exemplary embodiments thereof with reference to the attached drawings in which:
FIG. 1 is a circuit diagram of a non-volatile memory device according to an embodiment of the present invention;
FIG. 2 is a circuit diagram of a non-volatile memory device according to another embodiment of the present invention.
FIG. 3 is a circuit diagram illustrating a program operation of a non-volatile memory device according to an embodiment of the present invention;
FIG. 4 is a circuit diagram illustrating a program operation of a non-volatile memory device according to another embodiment of the present invention;
FIG. 5 is a circuit diagram illustrating a read operation of a non-volatile memory device according to an embodiment of the present invention;
FIG. 6 is a circuit diagram illustrating an erase operation of a non-volatile memory device according to an embodiment of the present invention; and
FIG. 7 is a cross-sectional view of a non-volatile memory device according to an embodiment.

### DETAILED DESCRIPTION OF THE INVENTION

The present invention will now be described more fully with reference to the accompanying drawings, in which exemplary embodiments of the invention are shown. The invention may, however, be embodied in many different forms and should not be construed as being limited to the embodiments set forth herein; rather, these embodiments are provided so that this disclosure will be thorough and complete, and will fully convey the concept of the invention to those skilled in the art. In the drawings, the sizes of elements may be exaggerated for explanatory conveniences.

A non-volatile memory device according to embodiments of the present invention may include an EEPROM device and a flash memory device, for example, but the scope of the present invention is not limited to this example.

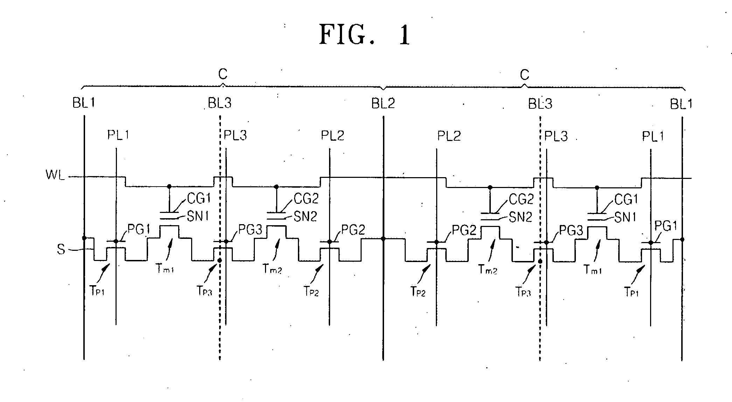

FIG. 1 is a circuit diagram of a non-volatile memory device according to an embodiment of the present invention. Referring to FIG. 1, the non-volatile memory device to which a pair of unit cells C are serially connected is shown. The number of unit cells C is just an example and does not limit the scope of the present invention. Thus, the non-volatile memory device may include only one unit cell C or three or more unit cells C. Hereinafter, firstly, the configuration of one unit cell C will be described.

One unit cell C includes first and second memory transistors Tₘ₁ and Tₘ₂ and first, second and third pass transistors Tₚ₁, Tₚ₂ and Tₚ₃, which are arranged in a string (a line) S. First and second bit lines BL1 and BL2 are connected to ends of the string S constituting the unit cell C, and a word line WL controls the first and second memory transistors Tₘ₁ and Tₘ₂ in common.

More specifically, the first and second bit lines BL1 and BL2 are arranged to cross the string S. That is, a direction in which the first and second bit lines BL1 and BL2 extend and a direction in which the string S extends may not coincide with each other. The first and second memory transistors Tₘ₁ and Tₘ₂ are included in the string S between the first and second bit lines BL1 and BL2.

The first memory transistor Tₘ₁ includes a first control gate CG1 and a first storage node SN1, and the second memory transistor Tₘ₂ includes a second control gate CG2 and a second storage node SN2. For example, the first and second memory transistors Tₘ₁ and Tₘ₂ may have a structure of a flash memory device. Here, the flash memory device may include a silicon/oxide/nitride/oxide/silicon (SONOS) memory device. In this case, the first and second storage nodes SN1 and SN2 may operate as a floating gate node or a charge trapping node. The first and second control gates CG1 and CG2 may be used to control the operations of the first and second memory transistors Tₘ₁ and Tₘ₂.

The first, second and third pass transistors Tₚ₁, Tₚ₂ and Tₚ₃ are included in the string S between the first bit line BL1 and the first memory transistor Tₘ₁, in the string S between the second bit line BL2 and the second memory transistor Tₘ₂ and in the string S between the first and second memory transistors Tₘ₁ and Tₘ₂, respectively. Accordingly, the first pass transistor Tₚ₁ may control so that a power of the first bit line BL1 can be applied to the first memory transistor Tₘ₁ and the second pass transistor Tₚ₂ may control so that a power of the second bit line BL2 can be applied to the second memory transistor Tₘ₂. The third pass transistor Tₚ₃ may control an electrical connection between the first and second memory transistors Tₘ₁ and Tₘ₂.

The first, second and third pass transistors Tₚ₁, Tₚ₂ and Tₚ₃ includes first, second and third pass gates PG1, PG2 and PG3, respectively. For example, the first, second and third pass transistors Tₚ₁, Tₚ₂ and Tₚ₃ may have a structure of a conventional MOS field effect transistor and the first, second and third pass gates PG1, PG2 and PG3 may be used to control their respective turn-on and turn-off.

As an alternative, a first pass line PL1, a second pass line PL2 and a third pass line PL3, each of which connected to the first pass gate PG1, the second pass gate PG2 and the third pass gate PG3, respectively, may be provided. The first, second and third pass lines PL1, PL2 and PL3 may be arranged to go across a string S. In a modified example of the current embodiment, the first, second and third pass lines PL1, PL2 and PL3 may be omitted and powers may be directly applied to the first, second and third pass gates PG1, PG2 and PG3.

The third bit line BL3 is connected to a channel of the third pass transistor Tₚ₃. Thus, the third bit line BL3 may be driven in the state where the third pass transistor Tₚ₃ is turned on. A word line WL may be connected to the first and second control gates CG1 and CG2 of the first and second memory transistors Tₘ₁ and Tₘ₂ in common. The word line WL may extend across the first, second and third bit lines BL1, BL2 and BL3, the first, second and third pass gates PG1, PG2 and PG3) and the first, second and third pass lines PL1, PL2 and PL3.

The structure of unit cells C arranged on the string S may be symmetrical. Only, the word line WL may be shared in the unit cells C of the string S. Furthermore, the first bit line BL1 or the second bit line BL2 may be shared in two adjacent unit cells C serially connected to the string S. The second bit line BL2 shared in the two unit cells C is illustrated in FIG. 1.

The non-volatile memory device according to the current embodiment is different from a conventional NAND type flash memory device in that the first and second control gates CG1 and CG2 of the serially-connected first and second memory transistors Tₘ₁ and Tₘ₂ are connected to one word line WL. The non-volatile memory device according to the current embodiment may be different from a conventional NOR type flash memory device in that the first and second memory transistors Tₘ₁, Tₘ₂ connected to one word line WL are serially connected to each other. Meanwhile, the non-volatile memory device according to the current embodiment has a similar feature to that of the conventional NAND type flash memory device in that the first and second memory transistors Tₘ₁ and Tₘ₂ are serially connected to each other and are driven. The non-volatile memory device according to the current embodiment has a similar feature to that of the conventional NOR type flash memory device in that the first and second memory transistors Tₘ₁ and Tₘ₂ can have access separately through the first, second and bit lines BL1, BL2 and BL3. Thus, the non-volatile memory device according to the current embodiment may have a shape in which the conventional NAND type flash memory device and the conventional NOR type flash memory device are combined.

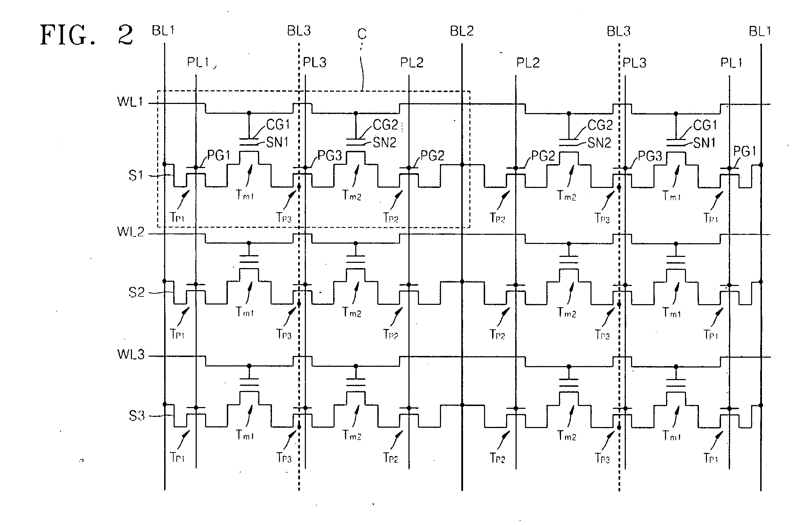

FIG. 2 is a circuit diagram of a non-volatile memory device according to another embodiment of the present invention. For example, the non-volatile memory device of FIG. 2 may be an array structure in which the non-volatile memory device of FIG. 1 is arranged in a row. Thus, a repeated description in FIGS. 1 and 2 will be omitted and like reference numerals denote like elements.

Referring to FIG. 2, first, second and third word lines WL1, WL2 and WL3 may refer to the word line WL of FIG. 1 and first, second and third strings S1, S2 and S3 may refer to the string S of FIG. 1. The first, second and third strings S1, S2 and S3 are arranged in a plurality of rows and the first, second and third word lines WL1, WL2 and WL3 are accordingly arranged in a plurality of rows.

The unit cells C may be arranged in an array shape. The first and second memory transistors Tₘ₁ and Tₘ₂ in the unit cells C arranged in the same row are serially connected, as described in FIG. 1. Meanwhile, the first and second memory transistors Tₘ₁ and Tₘ₂ in the unit cells C arranged in other rows may not be directly connected to each other. Only, the first, second and third bit lines BL1, BL2 and BL3 and the first, second and third pass lines PL1, PL2 and PL3 are shared in first, second and third strings S1, S2 and S2, respectively, and accordingly, may be shared in the unit cells C arranged in other rows.

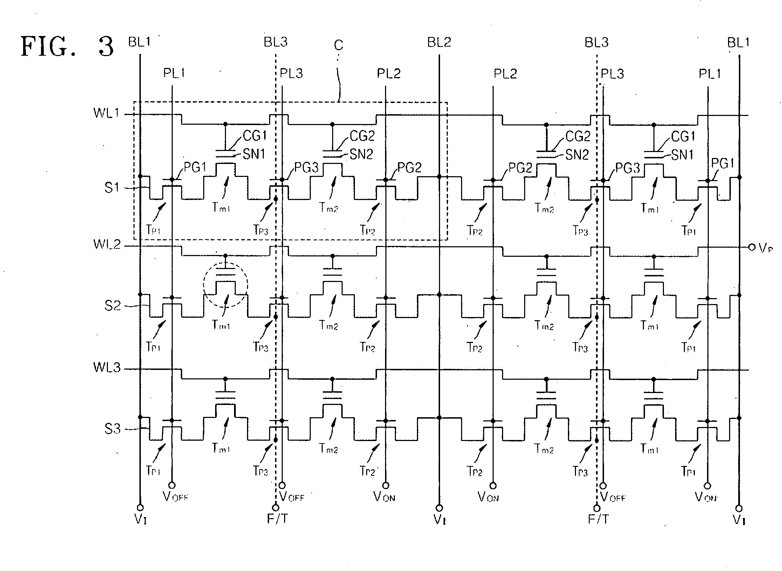

A method of operating a non-volatile memory device illustrated in FIGS. 1 and 2 will now be described with reference to FIGS. 3 through 6. FIGS. 3 through 6 illustrate a method of operating the non-volatile memory device of FIG. 2. However, it is obvious that the method of operating the non-volatile memory device of FIG. 2 can also be easily applied to the non-volatile memory device of FIG. 1.

FIG. 3 is a circuit diagram illustrating a program operation of a non-volatile memory device according to an embodiment of the present invention. A method of programming data by selecting a first memory transistor Tₘ₁ marked by a dotted line is explained in FIG. 3. In this case, a program uses an F-N tunneling method. More specifically, in order to select the second string S2, a program voltage Vₚ is applied to a second word line WL2. A turn-off voltage V_{OFF} is applied to the third pass line PL3 and the third bit line BL3 is floated (marked by F/T) so that the first and second memory transistors Tₘ₁ and Tₘ₂ can be electrically separated from each other. A ground voltage of 0V may be applied to bodies of the first and second memory transistors Tₘ₁ and Tₘ₂.

A program prevention voltage V_{I} is applied to the first and second bit lines BL1 and BL2, a turn-off voltage V_{OFF} is applied to a first pass line PL1 and a turn-on voltage V_{ON} is applied to a second pass line PL2. As a result, a first pass transistor Tₚ₁ is turned on and the second pass transistor Tₚ₂ is turned off. As such, the program prevention voltage V_{I} is selectively applied to a channel of the second memory transistor Tₘ₂. Accordingly, charges are injected into a first storage node SN1 at a channel of the first memory transistor Tₘ₁ using a tunneling method but tunneling of the charges is suppressed in the second memory transistor Tₘ₂.

Even though the method of programming data in the first memory transistor 1 Tₘ₁ has been described in FIG. 3, a method of programming data in the second memory transistor Tₘ₂ can also be easily implemented with reference to the above-described description. For example, in the above-described programming method, the turn-on voltage V_{ON} is applied to the first pass line PL1 and the turn-off voltage V_{OFF} is applied to the second pass line PL2 so that data can be selectively programmed in the second memory transistor Tₘ₂. As another example, the turn-off voltage V_{OFF} is applied to both the first and second pass lines PL1 and PL2 so that data can be simultaneously programmed in the first and second memory transistors Tₘ₁ and Tₘ₂.

The programming methods may be applied to other unit cells C and accordingly, the first and second memory transistors Tₘ₁ and Tₘ₂ in other unit cells C can be simultaneously programmed. In addition, it is obvious that a program voltage Vₚ is applied to first and third word lines WL1 and WL3 so that unit cells C in other rows can be selected.

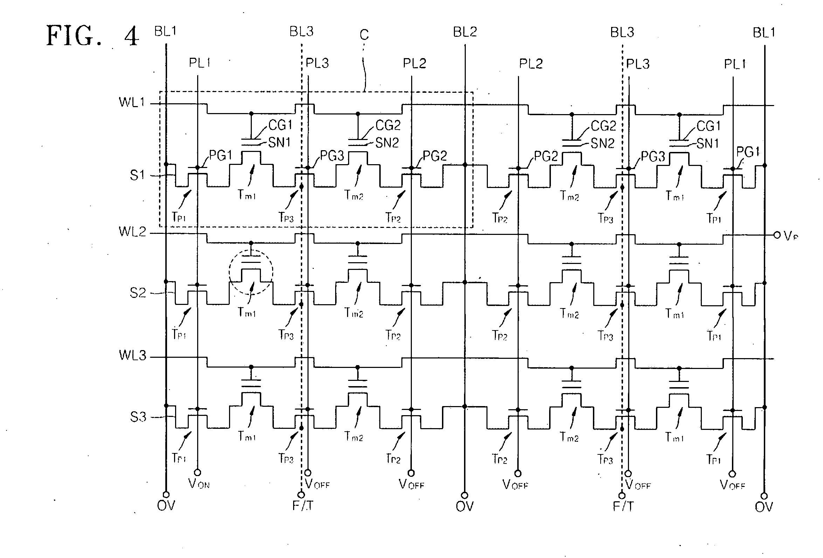

FIG. 4 is a circuit diagram illustrating a program operation of a non-volatile memory device according to another embodiment of the present invention. A method of programming data by selecting the first memory transistor Tₘ₁ marked by a dotted line is explained in FIG. 4. A program uses an F-N tunneling method like in FIG. 3. However, the first and second memory transistors Tₘ₁ and Tₘ₂ are selected by using a localized self-boosting (LSB) method. According to this, when a pulse type program voltage is applied, tunneling of charges selectively occurs in a portion in which a channel or body is wide so that the charges can be supplied within a short time.

More specifically, in order to select a second string S2, a pulse type program voltage is applied to a second word line WL2. A turn-off voltage V_{OFF} is applied to the third pass line PL3 and the third bit line BL3 is floated (marked by F/T) so that the first and second memory transistors Tₘ₁ and Tₘ₂ are electrically separated from each other.

A ground voltage of 0V is applied to the first and second bit lines BL1 and BL2, a turn-on voltage V_{ON} is applied to a first pass line PL1 and a turn-off voltage V_{OFF} is applied to a second pass line PL2. In this case, charges can be supplied to a channel of the first memory transistor Tₘ₁ from a channel of a first pass transistor Tₚ₁. However, a channel of the second memory transistor Tₘ₂ is disconnected to a channel of the second pass transistor Tₚ₂. Thus, data programming can be selectively possible only in the first memory transistor Tₘ₁.

The above-mentioned programming methods illustrated in FIGS. 3 and 4 employ advantages of the conventional NOR type and NAND type flash memory devices. That is, F-N tunneling is used such that a program efficiency is high, a program speed is fast and a random access is possible. Thus, a program interference caused by the first and second pass transistors Tₚ₁ and Tₚ₂ can be avoided. In addition, data can be programmed simultaneously in the plurality of memory transistors Tₘ₁ and Tₘ₂ such that a page program is possible.

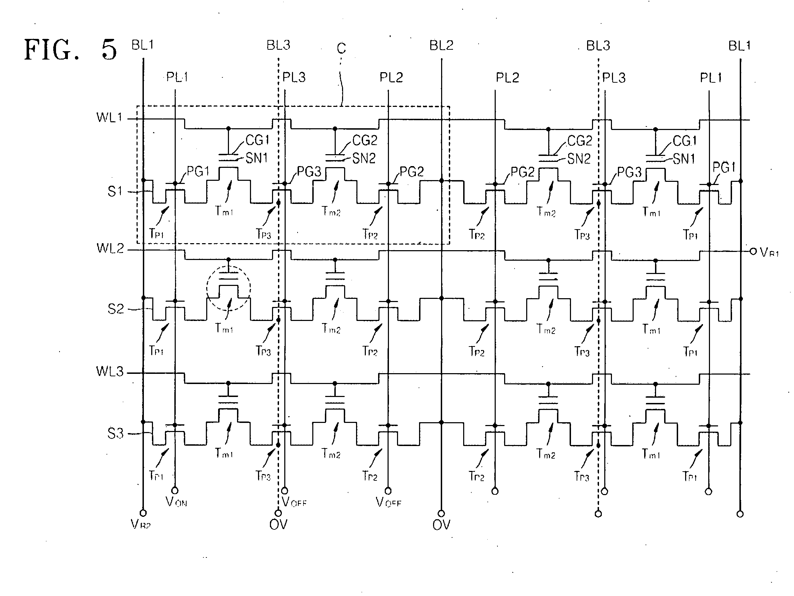

FIG. 5 is a circuit diagram illustrating a read operation of a non-volatile memory device according to an embodiment of the present invention. A method of reading data of the first memory transistor Tₘ₁ is explained in FIG. 5. A first read voltage V_{R1} is applied to a second word line WL2, so as to select a second row. A ground voltage of 0V is applied to a third bit line BL3 and a turn-on voltage V_{ON} is applied to a third pass line PL3. A second read voltage V_{R2} is applied to a first bit line BL1 and a turn-on voltage V_{ON} is applied to a first pass line PL1. As such, the flow of a current can be induced to the third bit line BL3 from the first bit line BL1 and data of the first memory transistor Tₘ₁ can be read from the flow of the current.

A method of reading data of the second memory transistor Tₘ₂ can be easily implemented from the above-described description of FIG. 5. For example, a second read voltage V_{R2} is applied to the second bit line BL2 instead of the first bit line BL1 and a turn-on voltage V_{ON} is applied to the second pass line PL2 instead of the first pass line PL1. As such, the flow of a current can be induced to the third bit line BL3 from the second bit line BL2. In addition, it is obvious that the first read voltage V_{R1} is applied to other word lines WL1 and WL3 instead of the second word line WL2 such that data in unit cells C arranged in other rows can be read.

The reading method illustrated in FIG. 5 employs advantages of the NOR type flash memory device. Thus, in the reading method illustrated in FIG. 5, a random access is possible and a read speed is fast.

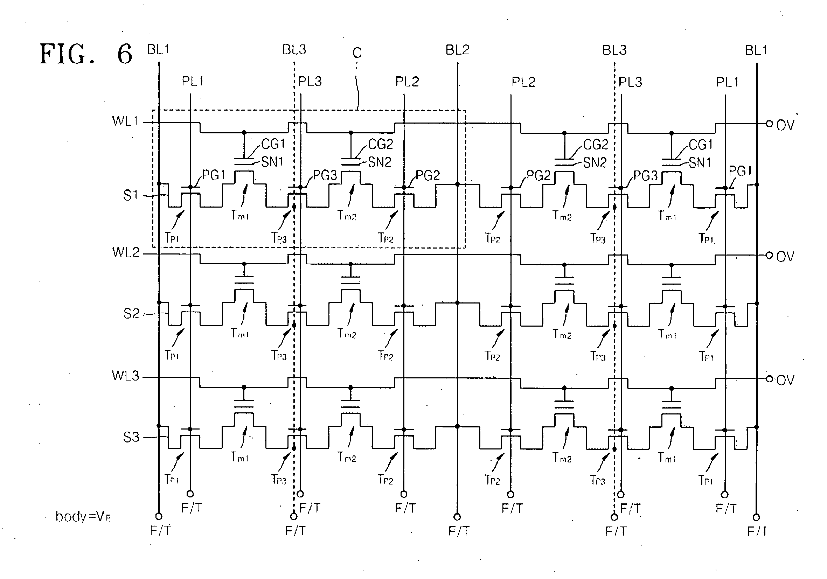

FIG. 6 is a circuit diagram illustrating an erase operation of a non-volatile memory device according to an embodiment of the present invention. A block erase method of erasing data in predetermined unit cells C at one time is explained in FIG. 6. A ground voltage of 0V is applied to first, second and third word lines WL1, WL2 and WL3 and an erase voltage V_{E} is applied to bodies of first and second memory transistors Tₘ₁ and Tₘ₂. All of first, second and third bit lines BL1, BL2 and BL3 and all of first, second and third pass lines PL1, PL2 and PL3 can be floated (marked by F/T). As a result, data programmed in first and second storage nodes SN1 and SN2 can be erased at one time.

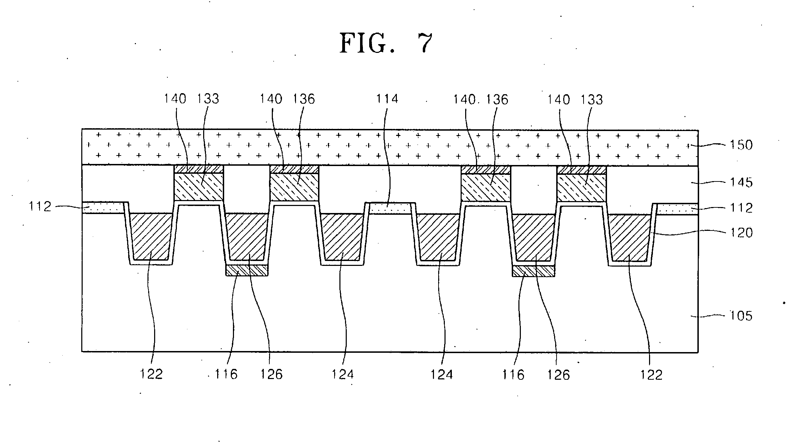

FIG. 7 is a cross-sectional view of a non-volatile memory device according to an embodiment of the present invention. The structure of FIG. 7 may correspond to the circuit of FIG. 1 and a repeated description thereof will be omitted.

Referring to FIG. 7, first and second bit line regions 112 and 114 are defined in a semiconductor substrate 105. For example, impurities are doped into the semiconductor substrate 105, thereby forming the first and second bit line regions 112 and 114. The semiconductor substrate 105 and the first and second bit line regions 112 and 114 may have impurities of opposite conductivity types. The first and second bit line regions 112 and 114 may correspond to the first and second bit lines BL1 and BL2 of FIG. 1.

First and second storage node layers 133 and 136 are formed on the semiconductor substrate 105 between the first and second bit line regions 112 and 114, respectively. For example, the first and second storage node layers 133 and 136 may include at least one layer selected from the group consisting of a polysilicon layer, a silicon nitride layer, silicon or metal dots and silicon or metal nano-crystals. A gate insulating layer 120 may be interposed between each of the first and second storage node layers 133 and 136 and the semiconductor substrate 105. The first and second storage node layers 133 and 136 may correspond to each of the first and second storage nodes SN1 and SN2 of FIG. 1 so that the first and second memory transistors Tₘ₁ and Tₘ₂ of FIG. 1 can be constituted respectively.

First, second and third pass gate electrodes 122, 124 and 126 are formed on the semiconductor substrate 105 between the first bit line region 112 and the first storage node layer 133, between the second bit line region 114 and the second storage node layer 136 and between the first and second storage node layers 133 and 136. A gate insulating layer 120 may be interposed between each of the first, second and third pass gate electrodes 122, 124 and 126 and the semiconductor substrate 105. The first, second and third pass gate electrodes 122, 124 and 126 may correspond to the first, second and third pass gates PG1, PG2 and PG3 of FIG. 1 so that the first, second and third transistors Tₚ₁, Tₚ₂, Tₚ₃ of FIG. 1 can be constituted respectively.

For example, the first, second and third pass gate electrodes 122, 124 and 126 may be recessed into the semiconductor substrate 105. In this case, a channel region under the first and second storage node layers 133 and 136 and a channel region under the first, second and third gate electrodes 122, 124 and 126 may be connected by only channels without the need for an additional impurity region (for example, a source region or drain region). Thus, the integration rate of the non-volatile memory device can be remarkably increased.

In a comparative example the first, second and third pass gate electrodes 122, 124 and 126 may be formed in a planar shape. In this case, an impurity region may be formed to a predetermined size between each of the first, second and third pass gate electrode 122, 124 and 126 and each of the first and second storage nodes 133 and 136.

The third bit line region 116 is formed in a portion of the semiconductor substrate 106 under the third pass gate electrode 126. For example, the third bit line region 116 may include a channel region of the third pass gate electrode 126. The third bit line region 116 may correspond to the third bit line BL3 of FIG. 1. A control gate electrode 150 is disposed to extend across the first and second storage node layers 133 and 136. The control gate electrode 150 is used as a word line (WL of FIG. 1) and simultaneously may be used as control gates (CG1 and CG2 of FIG. 1). A blocking dielectric film 140 may be interposed between the control gate electrode 150 and each of the first and second storage node layers 133 and 136. An interlevel dielectric (ILD) film 145 may be interposed between the control gate electrode 150 and the semiconductor substrate 105.

The non-volatile memory device of FIG. 7 may be divided into two unit cells C., as described with reference to FIG. 1. In this case, the control gate electrode 150 may be shared in the two unit cells C. Furthermore, the second bit line region 114 between the two unit cells C may be shared in the unit cells. In addition, it is obvious that the non-volatile memory device of FIG. 7 can extend in an array arrangement structure of FIG. 2.

Operating characteristics of the non-volatile memory device illustrated in FIG. 7 may be described with reference to the description of FIGS. 3 through 6.

While the present invention has been particularly shown and described with reference to exemplary embodiments thereof, it will be understood by those skilled in the art that various changes in form and details may be made therein without departing from the scope of the invention as defined by the following claims.

## Claims

1. A non-volatile memory device comprising:
a semiconductor substrate (105) in which first and second bit line regions (112,114) are defined;
first and second storage node layers (133, 136) respectively formed on the semiconductor substrate between the first and second bit line regions;
a first pass gate electrode (122) formed on the semiconductor substrate defining a first pass transistor;
a second pass gate electrode (124) formed on the semiconductor substrate defining a second pass transistor;
a third pass gate electrode (126) formed on the semiconductor substrate between the first and second storage node layers defining a third pass transistor;
a third bit line region (116); and
a control gate electrode (150) extending across the first and second storage node layers;
**characterised in that** the first, second and third pass gate electrodes (122,124,126) are recessed into the semiconductor substrate;
the third bit line region (116) is formed in a portion of the semiconductor substrate under the third pass gate electrode;
the first pass gate electrode (122) is formed between the first bit line region and the first storage node layer; and
the second pass gate electrode (124) is formed between the second bit line region and the second storage node layer.

2. The device of claim 1, wherein the first and second bit line regions (112,114) include doped impurities in the semiconductor substrate.

3. The device of claim 1, wherein the first and second storage node layers (133,136) comprises at least one layer selected from the group of consisting of a polysilicon layer, a silicon nitride layer, silicon or metal dots and silicon or metal nano-crystals.

4. The device of claim 1, wherein the control gate electrode (150) is used as a word line.

5. A non-volatile memory device according to claim 1, comprising:
a string including the first, second and third pass transistors and first and second memory transistors; and
a word line connected to the control gate of each of the first and second memory transistors in common;
wherein the first and second bit line regions form first and second bit lines connected to one string and cross the string;
the first and second memory transistors included in the string between the first and second bit lines each have the control gate electrode (150) and a respective storage node layer (133,136);
the first pass gate electrode (122) defines a first pass transistor included in the string between the first bit line and the first memory transistor and including a first pass gate; the second pass gate electrode (124) defines a second pass transistor included in the string between the second memory transistor and the second bit line and including a second pass gate;
the third pass gate electrode (126) defines a third pass transistor included in the string between the first and second memory transistors and including a third pass gate.

6. The non-volatile memory device of claim 5, wherein the word line (150) extends across the first, second and third bit lines.

7. The non-volatile memory device of claim 5 or 6, wherein the first, second and third pass gates extend across the word line.

8. The non-volatile memory device of any of claims 5 to 7, wherein the first and second memory transistors have a structure of a flash memory device.

9. The non-volatile memory device of claim 8, wherein the storage node layer (133,136) of each of the first and second memory transistors operates as a floating gate node or a charge trapping node.

10. A non-volatile memory device having unit cells formed of the non-volatile memory device of any preceding claim, the non-volatile memory device comprising a plurality of the said unit cells serially arranged on the string, wherein the word line (150) is shared in the unit cells.

11. The non-volatile memory device of claim 10, wherein the first or second bit line is shared in two adjacent unit cells among the unit cells.

12. A non-volatile memory device having unit cells formed of the non-volatile memory device of any of claims 1 to 9, the-non-volatile memory device comprising:
a plurality of the said unit cells arranged in a plurality of rows;
a first pass line connecting the first pass gates in the unit cells arranged in the rows in common;
a second pass line connecting the second pass gates in the unit cells arranged in the rows in common; and
a third pass line connecting the third pass gates in the unit cells arranged in the rows in common,
wherein the first, second and third bit lines are shared in the unit cells arranged in the rows.

13. A method of operating a non-volatile memory device according to any of claims 5 to 12, the method comprising:
selecting at least one memory transistor of the first and second memory transistors to program data in the selected memory transistor using tunneling of charges;
selecting at least one memory transistor of the first and second memory transistors to read data in the selected memory transistor; and
erasing the data in the first and second memory transistors at one time.

14. The method of claim 13, wherein the programming of the data comprises:
applying a program voltage to the word line;
applying a program prevention voltage to the first and second bit lines;
applying a turn-off voltage to the third pass gate;
applying a turn-off voltage to one pass gate selected from the first and second pass gates; and
applying a turn-on voltage to the other pass gate.

15. The method of claim 13 or 14, wherein the programming of the data comprises:
applying a program voltage to the word line;
applying a ground voltage to the first and second bit lines;
applying a turn-off voltage to the third pass gate;
applying a tum-on voltage to one pass gate selected from the first and second pass gates; and
applying a turn-off voltage to the other pass gate.

16. The method of claim 13, 14 or 15, wherein the reading of the data comprises:
applying a first read voltage to the word line;
applying a second read voltage to at least one bit line of the first and second bit lines; and
applying a ground voltage to the third bit line.

17. The method of any of claims 13 to 16, wherein the erasing of the data comprises:
applying a ground voltage to the word line; and
applying an erase voltage to bodies of the first and second memory transistors.

## Patentansprüche

1. Nichtflüchtiges Speicherbauelement, umfassend:
ein Halbleitersubstrat (105), in dem eine erste und eine zweite Bitleitungsregion (112, 114) definiert sind,
eine erste und eine zweite Speicherknotenschicht (133, 136), die jeweils auf dem Halbleitersubstrat zwischen der ersten und zweiten Bitleitungsregion definiert sind,
eine erste Passgate-Elektrode (122), die auf dem Halbleitersubstrat ausgebildet ist und einen ersten Passtransistor definiert,
eine zweite Passgate-Elektrode (124), die auf dem Halbleitersubstrat ausgebildet ist und einen zweiten Passtransistor definiert,
eine dritte Passgate-Elektrode (126), die auf dem Halbleitersubstrat zwischen der ersten und zweiten Speicherknotenschicht ausgebildet ist und
einen dritten Passtransistor definiert,
eine dritte Bitleitungsregion (116) und
eine Steuergate-Elektrode (150), die sich über die erste und zweite Speicherknotenschicht erstreckt,
**dadurch gekennzeichnet, dass** die erste, zweite und dritte Passgate-Elektrode (122, 124, 126) in dem Halbleitersubstrat eingelassen sind,
die dritte Bitleitungsregion (116) in einem Abschnitt des Halbleitersubstrats unter der dritten Passgate-Elektrode ausgebildet ist,
die erste Passgate-Elektrode (122) zwischen der ersten Bitleitungsregion und der ersten Speicherknotenschicht ausgebildet ist und
die zweite Passgate-Elektrode (124) zwischen der zweiten Bitleitungsregion und der zweiten Speicherknotenschicht ausgebildet ist.

2. Bauelement nach Anspruch 1, wobei die erste und zweite Bitleitungsregion (112, 114) dotierte Fremdstoffe im Halbleitersubstrat umfassen.

3. Bauelement nach Anspruch 1, wobei die erste und zweite Speicherknotenschicht (133, 136) mindestens eine Schicht ausgewählt aus der Gruppe bestehend aus einer Polysiliciumschicht, einer Siliciumnitridschicht, Silicium- oder Metalldots und Silicium- oder Metall-Nanokristallen umfassen.

4. Bauelement nach Anspruch 1, wobei die Steuergate-Elektrode (150) als Wortleitung verwendet ist.

5. Nichtflüchtige Speicherbauelement nach Anspruch 1, umfassend:
einen String, der den ersten, zweiten und dritten Passtransistor und einen ersten und einen zweiten Speichertransistor umfasst, und
eine Wortleitung, die mit dem Steuergate jedes von dem ersten und zweiten Speichertransistor gemeinsam verbunden ist,
wobei die erste und zweite Bitleitungsregion erste und zweite Bitleitungen bilden, die mit einem String verbunden sind und den String kreuzen, die im String zwischen der ersten und zweiten Bitleitung vorgesehenen ersten und zweiten Speichertransistoren jeweils die Steuergate-Elektrode (150) und eine zugehörige Speicherknotenschicht (133, 136) aufweisen,
die erste Passgate-Elelctrode (122) einen ersten Passtransistor definiert, der im String zwischen der ersten Bitleitung und dem ersten Speichertransistor vorgesehen ist und ein erstes Passgate aufweist, die zweite Passgate-Elektrode (124) einen zweiten Passtransistor definiert, der im String zwischen dem zweiten Speichertransistor und der zweiten Bitleitung vorgesehen ist und ein zweites Passgate aufweist,
die dritte Passgate-Elektrode (126) einen dritten Passtransistor definiert, der im String zwischen dem ersten und zweiten Speichertransistor vorgesehen ist und ein drittes Passgate aufweist.

6. Nichtflüchtiges Speicherbauelement nach Anspruch 5, wobei die Wortleitung (150) sich über die erste, zweite und dritte Bitleitung erstreckt.

7. Nichtflüchtiges Speicherbauelement nach Anspruch 5 oder 6, wobei das erste, zweite und dritte Passgate sich über die Wortleitung erstrecken.

8. Nichtflüchtiges Speicherbauelement nach einem der Ansprüche 5 bis 7, wobei der erste und zweite Speichertransistor eine Struktur eines Flash-Speicherbauelements aufweisen.

9. Nichtflüchtiges Speicherbauelement nach Anspruch 8, wobei die Speicherknotenschicht (133, 136) jedes von dem ersten und zweiten Speichertransistor als Floating-Gateknoten oder als Ladungseinfangknoten funktioniert.

10. Nichtflüchtiges Speicherbauelement mit aus dem nichtflüchtigen Speicherbauelement nach einem der vorhergehenden Ansprüche gebildeten Einheitszellen, wobei das nichtflüchtige Speicherbauelement eine Mehrzahl der Einheitszellen seriell auf dem String angeordnet aufweist, wobei die Wortleitung, (150) in den Einheitszellen gemeinsam genutzt wird.

11. Nichtflüchtiges Speicherbauelement nach Anspruch 10, wobei die erste oder zweite Bitleitung in zwei benachbarten unter den Einheitszellen gemeinsam genutzt wird.

12. Nichtflüchtiges Speicherbauelement mit aus dem nichtflüchtigen Speicherbauelement nach einem der Ansprüche 1 bis 9 gebildeten Einheitszellen, wobei das nichtflüchtige Speicherbauelement umfasst:
eine Mehrzahl der Einheitszellen angeordnet in einer Mehrzahl von Zeilen,
eine erste Passleitung, die die ersten Passgates in den in Zeilen angeordneten Einheitszellen gemeinsam verbindet,
eine zweite Passleitung, die die zweiten Passgates in den in Zeilen angeordneten Einheitszellen gemeinsam verbindet, und
eine dritte Passleitung, die die dritten Passgates in den in Zeilen angeordneten Einheitszellen gemeinsam verbindet,
wobei die erste, zweite und dritte Bitleitung in den in Zeilen angeordneten Einheitszellen gemeinsam genutzt werden.

13. Verfahren zum Betrieb eines nichtflüchtigen Speicherbauelements nach einem der Ansprüche 5 bis 12, wobei das Verfahren umfasst:
Auswählen mindestens eines Speichertransistors aus dem ersten und zweiten Speichertransistor zum Programmieren von Daten in den ausgewählten Speichertransistor unter Verwendung von Ladungstunnelung, Auswählen mindestens eines Speichertransistors aus dem ersten und zweiten Speichertransistor zum Lesen von Daten in dem ausgewählten Speichertransistor und
Löschen der Daten im ersten und zweiten Speichertransistor gleichzeitig.

14. Verfahren nach Anspruch 13, wobei das Programmieren von Daten umfasst:
Anlegen einer Programmierspannung an die Wortleitung,
Anlegen einer Programmiersperrspannung an die erste und zweite Bitleitung,
Anlegen einer Abschaltspannung an das dritte Passgate,
Anlegen einer Abschaltspannung an ein Passgate ausgewählt aus dem ersten und zweiten Passgate und
Anlegen einer Anschaltspannung an das andere Passgate.

15. Verfahren nach Anspruch 13 oder 14, wobei das Programmieren von Daten umfasst:
Anlegen einer Programmierspannung an die Wortleitung,
Anlegen einer Massespannung an die erste und zweite Bitleitung,
Anlegen einer Abschaltspannung an das dritte Passgate,
Anlegen einer Anschaltspannung an ein Passgate ausgewählt aus dem ersten und zweiten Passgate und
Anlegen einer Abschaltspannung an das andere Passgate.

16. Verfahren nach Anspruch 13, 14 oder 15, wobei das Lesen von Daten umfasst:
Anlegen einer ersten Lesespannung an die Wortleitung,
Anlegen einer zweiten Lesespannung an mindestens eine Bitleitung der ersten und zweiten Bitleitung und
Anlegen einer Massespannung an die dritte Bitleitung.

17. Verfahren nach einem der Ansprüche 13 bis 16, wobei das Löschen von Daten umfasst:
Anlegen einer Massespannung an die Wortleitung und
Anlegen einer Löschspannung an Körper des ersten und zweiten Speichertransistors.

## Revendications

1. Dispositif de mémoire rémanente comprenant:
un substrat semi-conducteur (105) dans lequel des première et deuxième régions de lignes de bits (112, 114) sont définies ;
des première et seconde couches de noeuds de stockage (133, 136) formées respectivement sur le substrat semi-conducteur entre les première et deuxième régions de lignes de bits ;
une première électrode de porte de passage (122) formée sur le substrat semi-conducteur définissant un premier transistor ballast ;
une deuxième électrode de porte de passage (124) formée sur le substrat semi-conducteur définissant un deuxième transistor ballast ;
une troisième électrode de porte de passage (126) formée sur le substrat semi-conducteur entre les première et seconde couches de noeuds de stockage définissant un troisième transistor ballast ;
une troisième région de ligne de bits (116) ; et
une électrode de porte de commande (150) s'étendant en travers des première et seconde couches de noeuds de stockage ;
**caractérisé en ce que** les première, deuxième et troisième électrodes de porte de passage (122, 124, 126) sont en retrait dans le substrat semi-conducteur ;
la troisième région de ligne de bits (116) est formée dans une partie du substrat semi-conducteur en dessous de la troisième électrode de porte de passage ;
la première électrode de porte de passage (122) est formée entre la première région de ligne de bits et la première couche de noeud de stockage ; et
la deuxième électrode de porte de passage (124) est formée entre la deuxième région de ligne de bits et la seconde couche de noeud de stockage.

2. Dispositif selon la revendication 1, dans lequel les première et deuxième régions de lignes de bits (112, 114) comportent des impuretés dopées dans le substrat semi-conducteur.

3. Dispositif selon la revendication 1, dans lequel les première et seconde couches de noeuds de stockage (133, 136) comprennent au moins une couche sélectionnée dans le groupe consistant en une couche de polysilicium, une couche de nitrure de silicium, des points de silicium ou de métal et des nanocristaux de silicium ou de métal.

4. Dispositif selon la revendication 1, dans lequel l'électrode de porte de commande (150) est utilisée comme ligne de mots.

5. Dispositif de mémoire rémanente selon la revendication 1, comprenant :
une chaîne comportant les premier, deuxième et troisième transistors ballast et des premier et second transistors de mémoire ; et
une ligne de mots connectée à l'électrode de commande de chacun des premier et second transistors de mémoire en commun ;
dans lequel les première et deuxième régions de lignes de bits forment des première et deuxième lignes de bits connectées à une même chaîne et croisent la chaîne ;
les premier et second transistors de mémoire inclus dans la chaîne entre les première et deuxième lignes de bits ont chacun l'électrode de porte de commande (150) et une couche de noeud de stockage respective (133, 136) ;
la première électrode de porte de passage (122) définit un premier transistor ballast inclus dans la chaîne entre la première ligne de bits et le premier transistor de mémoire et comportant une première porte de passage ; la deuxième électrode de porte de passage (124) définit un deuxième transistor ballast inclus dans la chaîne entre le second transistor de mémoire et la deuxième ligne de bits et comportant une deuxième porte de passage ;
la troisième électrode de porte de passage (126) définit un troisième transistor ballast inclus dans la chaîne entre les premier et second transistors de mémoire et comportant une troisième porte de passage.

6. Dispositif de mémoire rémanente selon la revendication 5, dans lequel la ligne de mots (150) s'étend en travers des première, deuxième et troisième lignes de bits.

7. Dispositif de mémoire rémanente selon la revendication 5 ou 6, dans lequel les première, deuxième et troisième portes de passage s'étendent en travers de la ligne de mots.

8. Dispositif de mémoire rémanente selon l'une quelconque des revendications 5 à 7, dans lequel les premier et second transistors de mémoire ont une structure de dispositif de mémoire flash.

9. Dispositif de mémoire rémanente selon la revendication 8, dans lequel la couche de noeud de stockage (133, 136) de chacun des premier et second transistors de mémoire fonctionne comme noeud à grille flottante ou noeud de piégeage de charges.

10. Dispositif de mémoire rémanente ayant des cellules unitaires formé du dispositif de mémoire rémanente selon l'une quelconque des revendications précédentes, le dispositif de mémoire rémanente comprenant une pluralité desdites cellules unitaires agencées sériellement sur la chaîne, dans lequel la ligne de mots (150) est partagée dans les cellules unitaires.

11. Dispositif de mémoire rémanente selon la revendication 10, dans lequel la première ou la deuxième ligne de bits est partagée dans deux cellules unitaires adjacentes parmi les cellules unitaires.

12. Dispositif de mémoire rémanente ayant des cellules unitaires formé du dispositif de mémoire rémanente selon l'une quelconque des revendications 1 à 9, le dispositif de mémoire rémanente comprenant :
une pluralité desdites cellules unitaires agencées dans une pluralité de rangées ;
une première ligne de passage connectant les premières portes de passage dans les cellules unitaires agencées dans les rangées en commun ;
une deuxième ligne de passage connectant les deuxièmes portes de passage dans les cellules unitaires agencées dans les rangées en commun ; et
une troisième ligne de passage connectant les troisièmes portes de passage dans les cellules unitaires agencées dans les rangées en commun,
dans lequel les première, deuxième et troisième lignes de bits sont partagées dans les cellules unitaires agencées dans les rangées.

13. Procédé d'exploitation d'un dispositif de mémoire rémanente selon l'une quelconque des revendications 5 à 12, le procédé comprenant :
la sélection d'au moins un transistor de mémoire des premier et second transistors de mémoire afin de programmer des données dans le transistor de mémoire sélectionné par tunnelage des charges ;
la sélection d'au moins un transistor de mémoire des premier et second transistors de mémoire afin de lire des données dans le transistor de mémoire sélectionné ; et
l'effacement des données dans les premier et second transistors de mémoire simultanément.

14. Procédé selon la revendication 13, dans lequel la programmation des données comprend :
l'application d'une tension de programme à la ligne de mots ;
l'application d'une tension d'empêchement de programme aux première et deuxième lignes de bits ;
l'application d'une tension de désactivation à la troisième porte de passage ;
l'application d'une tension de désactivation à une porte de passage sélectionnée parmi les première et deuxième portes de passage ; et
l'application d'une tension d'activation à l'autre porte de passage.

15. Procédé selon la revendication 13 ou 14, dans lequel la programmation des données comprend :
l'application d'une tension de programme à la ligne de mots ;
l'application d'une tension de masse aux première et deuxième lignes de bits ;
l'application d'une tension de désactivation à la troisième porte de passage ;
l'application d'une tension d'activation à une porte de passage sélectionnée parmi les première et deuxième portes de passage ; et
l'application d'une tension de désactivation à l'autre porte de passage.

16. Procédé selon la revendication 13, 14 ou 15, dans lequel la lecture des données comprend :
l'application d'une première tension de lecture à la ligne de mots ;
l'application d'une seconde tension de lecture à au moins une ligne de bits des première et deuxième lignes de bits ; et
l'application d'une tension de masse à la troisième ligne de bits.

17. Procédé selon l'une quelconque des revendications 13 à 16, dans lequel l'effacement des données comprend :
l'application d'une tension de masse à la ligne de mots ; et
l'application d'une tension d'effacement aux corps des premier et second transistors de mémoire.
